(19) Europäisches Patentamt
European Patent Office
Office européen des brevets

(11) **EP 2 309 559 B1**

(12) **FASCICULE DE BREVET EUROPEEN**

(45) Date de publication et mention
de la délivrance du brevet:
**29.05.2013 Bulletin 2013/22**

(51) Int Cl.:
*H01L 41/314* *(2013.01)*   *H01L 41/29* *(2013.01)*
*H01L 41/09* *(2006.01)*   *H01L 41/332* *(2013.01)*
*H01L 41/047* *(2006.01)*

(21) Numéro de dépôt: **10186357.9**

(22) Date de dépôt: **04.10.2010**

(54) **Structure d'actionnement piézoélectrique comportant une jauge de contrainte piézorésistive intégrée et son procédé de réalisation**

Piezoelektrische Erregerstruktur mit integriertem piezoresistivem Dehnmessstreifen und Herstellungsverfahren dafür

Piezoelectric actuating structure comprising an integrated piezoresistive strain gauge and manufacturing method thereof

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.10.2009 FR 0904774**

(43) Date de publication de la demande:
**13.04.2011 Bulletin 2011/15**

(73) Titulaire: **Commissariat à l'Énergie Atomique et aux Énergies Alternatives**
**75015 Paris (FR)**

(72) Inventeurs:
• **Cueff, Matthieu**
**38100, GRENOBLE (FR)**
• **Defay, Emmanuel**
**38340, VOREPPE (FR)**
• **Perruchot, François**
**38000, GRENOBLE (FR)**
• **Rey, Patrice**
**38430, SAINT JEAN DE MOIRANS (FR)**

(74) Mandataire: **Esselin, Sophie et al**
**Marks & Clerk France**
**Conseils en Propriété Industrielle**
**Immeuble Visium**
**22, Avenue Aristide Briand**
**94117 Arcueil Cedex (FR)**

(56) Documents cités:
**GB-A- 2 365 206      US-A- 6 075 585**
**US-A1- 2005 009 197      US-A1- 2005 051 515**
**US-A1- 2005 150 280**

**Description**

Le domaine de l'invention est celui des actionneurs piézoélectriques de type membrane, poutre encastrée-libre, poutre encastrée-encastrée qui permettent de réaliser des dispositifs hautement intégrés.

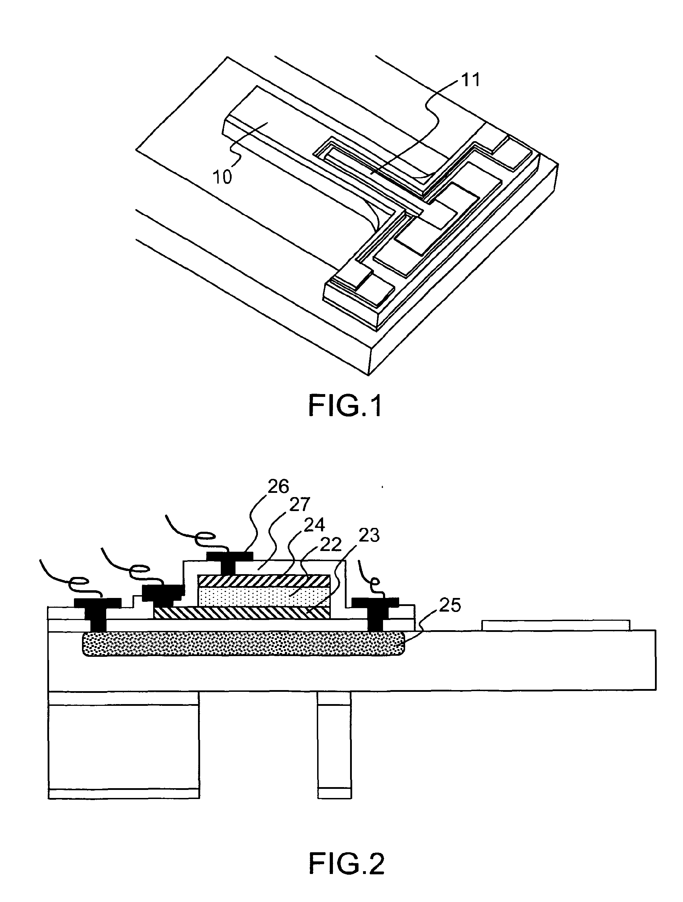

De manière générale, dans ces dispositifs, l'effet piézoélectrique mis en jeu est réversible et l'on peut mesurer une déflexion par une jauge piézoélectrique. La réalisation d'une telle jauge sur un actionneur piézoélectrique peut être mise en oeuvre par photolithographie. Une partie de l'électrode supérieure sert de capteur et l'autre d'actionneur. C'est ce qui a été réalisé par T. Kobayashi et al. « A fatigue test method for Pb(Zr,Ti)O3 thin films by using MEMS-based self-sensitive piezoelectric microcantilevers » Kobayashi T., Maeda R., Itoh T., National Institute of Advanced Industrial Science and Technology, Journal of Micromechanics and Microengineering, 18 (2008), 115007, 6 pages et qui est illustré en figure 1 qui montre une jauge piézoélectrique 11 associée à un actionneur piézoélectrique 10.

La densité de charges générées par le matériau piézoélectrique est proportionnelle à la contrainte appliquée sur le matériau. Les contraintes les plus importantes sont situées à l'encastrement. De plus, la quantité totale de charges récupérées est aussi proportionnelle à la surface de l'électrode. Pour récupérer le maximum de charges à un niveau de contraintes fixé, il faut donc se placer à l'encastrement et avoir la plus grande surface d'électrode possible. Cependant, si l'on augmente la surface dédiée à mesurer la déflexion, on réduit d'autant celle servant à l'actuation. De plus, si l'on veut avoir la déflexion maximale, il faut favoriser l'actionnement piézoélectrique au niveau de l'encastrement.

Dans cette configuration, la mesure de déflexion et l'actionnement sont fortement en concurrence. Afin de réaliser des dispositifs où l'actionnement et la mesure de déflexion sont tous les deux complètement intégrés, il est nécessaire d'utiliser un autre type de jauge pour la mesure de déflexion.

A ce titre, il est également connu d'utiliser des jauges piézorésistives intégrées, la mesure de déflexion par de telles jauges de contraintes étant notamment très intéressante dans les micro et nano systèmes électromécaniques (MEMS et NEMS) car celles-ci peuvent être complètement intégrées donc faciles à réaliser. Ces jauges sont utilisées dans tout type de capteurs (chimiques, biologiques, inertiels, etc.) et peuvent être de dimensions réduites puisque le signal n'est plus proportionnel à la surface de la jauge mais à sa longueur.

On entend par jauge piézorésistive, une jauge dont la résistance électrique est modifiée par l'action d'une contrainte mécanique due à une déformation.

La plupart des applications utilisent des jauges piézorésistives à base de silicium dopé p. Les jauges sont directement réalisées sur le substrat silicium. Ce matériau permet d'avoir des facteurs de jauges très importants (typiquement supérieur à 20). Cependant elles sont très sensibles aux variations de température, ce qui augmente le bruit thermique. Leur résistance est également très importante, ce qui limite le courant que l'on peut faire passer dans ces jauges. De plus, la réalisation de ces jauges nécessite des techniques de fabrication compliquée et chère (implantation ionique et/ou épitaxie). C'est ce type de jauge qui a été utilisé par J. Lu et al , « High-Q and CMOS compatible single crystal silicon cantilever with separated on-chip piezoelectric actuator for ultra-sensitive mass detection », Lu J., Ikehara T., Zhang Y., Mihara T., Itoh T., Maeda R., National Institute of Advanced Industrial Science and Technology, MEMS 2008, January 13-17 2008, Tucson, AZ, USA et présenté en figure 2. Plus précisément, selon ce type de dispositif utilisant une jauge piézorésistive, un actionneur comprend un matériau piézoélectrique 22 compris entre une électrode inférieure 23 et une électrode supérieure 24, le substrat de silicium étant en région 25 localement dopé par exemple par des ions de bore, l'ensemble des prises de contact 26 pouvant typiquement être assuré par un bicouche Au/Cr , l'actionneur étant protégé par une couche 27 de type $SiO_2$.

Il a déjà également été proposé des jauges de contraintes métalliques pour certaines applications. Le facteur de jauge est alors plus faible que pour les jauges silicium (typiquement de l'ordre de 2) mais la résistance de la jauge est plus faible, ce qui permet d'augmenter la densité de courant. On retrouve ainsi le même niveau de signal qu'avec les jauges silicium. Le bruit de mesure obtenu est également limité, ce qui permet d'obtenir une sensibilité équivalente à celle des jauges piézorésistives. C'est notamment l'objet du brevet US 2009/003804 de H. Tang et al : « Metallic thin film piezoresistive transduction in micromechanical and nanomechanical devices and its application in self-sensing SPM probes », Tang H., Li M., Roukes M. L., California Institute of Technology, US 2009/ 0038404 A1, dont un exemple d'application est le microscope à force atomique, présenté figure 3.

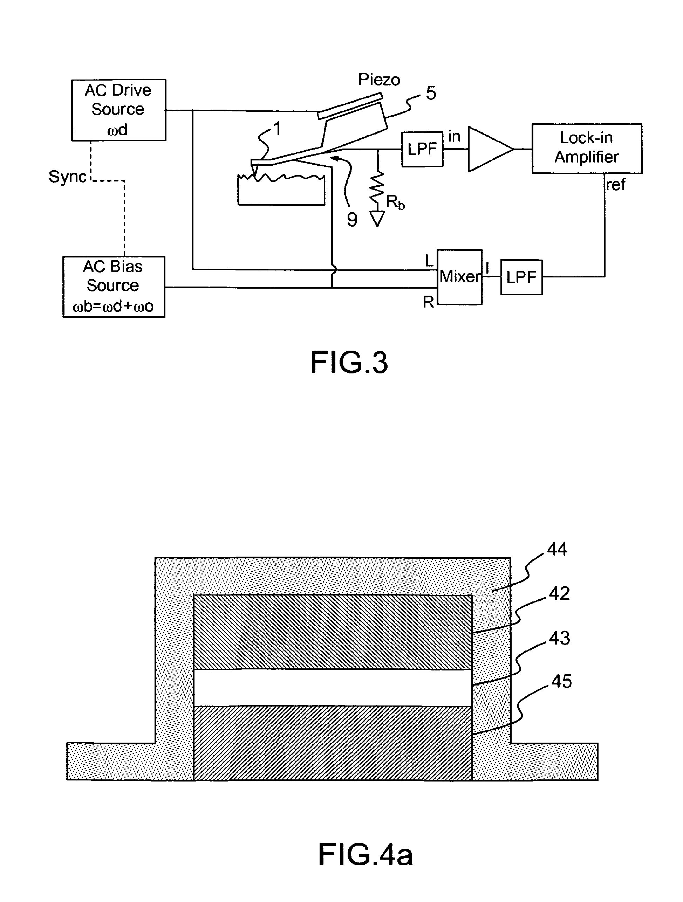

La figure 3 est le schéma d'une pointe de microscope à force atomique utilisant un actionnement piézoélectrique 5 et une mesure de déflection de la pointe 1 par une jauge de contraintes métallique 9.

La réalisation de ces jauges nécessite cependant des étapes de réalisation coûteuses en microélectronique et qui ne sont pas sans influence sur le dispositif.

Une structure d'actionnement piézoélectrique selon le préambule de la revendication 1 est divulguée dans US 6 075 585.

Il convient donc de trouver une façon de mesurer la déflexion d'un actionneur piézoélectrique pour réaliser un dispositif tout intégré sans pour autant alourdir sa réalisation.

En effet, en synthèse les solutions de l'art connu proposent des empilements d'actionneur piézoélectrique de type : couche élastique/électrode inférieure/matériau piézoélectrique/électrode supérieure comme illustré en figure 1 et pour intégrer la mesure de déflexion, soit de séparer l'empilement piézoélectrique en une zone servant à l'actionnement et une zone servant à la mesure, soit d'utiliser une jauge piézorésistive pouvant être en silicium.

Dans le cas d'une jauge piézoélectrique telle que celle illustrée en figure 1, il convient de faire un compromis entre la surface dédiée à la mesure et la surface dédiée à l'actionnement.

Par ailleurs, les jauges piézorésistives et les jauges de contraintes métalliques sont réalisées par des étapes technologiques spécifiques et coûteuses et complexifient l'empilement. En effet, les actionneurs piézoélectriques connus comportant une jauge de contraintes métallique sont réalisés par un empilement de couches réalisant indépendamment l'actionneur et la jauge de contraintes. Cette dernière est par exemple réalisée par une couche métallique disposée sous la couche élastique de l'empilement réalisant l'actionneur piézoélectrique.

Dans ce contexte et afin d'obtenir des dispositifs les plus intégrés possibles, la présente invention propose une solution dans laquelle les jauges de contraintes piézorésistives sont réalisées selon un technologie astucieuse et simple.

Plus précisément la présente invention a pour objet une structure d'actionnement piézoélectrique comportant au moins une jauge de contraintes et au moins un actionneur réalisé à partir d'un empilement à la surface d'un support d'au moins une couche de matériau piézoélectrique disposée entre une couche d'électrode inférieure et une couche d'électrode supérieure, au moins une partie de l'empilement formant l'actionneur étant disposé au dessus d'une cavité réalisée dans le support **caractérisée en ce que** la jauge de contrainte est une jauge piézorésistive située dans la couche d'électrode supérieure et/ou la couche d'électrode inférieure, la ou lesdites couches comportant des discontinuités d'électrodes permettant la réalisation de ladite jauge piézorésistive.

Selon une variante de l'invention, la jauge piézorésistive est réalisée dans au moins une partie de la couche d'électrode supérieure et/ou de la couche d'électrode inférieure située au-dessus de la cavité.

Selon une variante de l'invention, ladite jauge piézorésistive est réalisée sur au moins une partie du pourtour de l'électrode supérieure et/ou inférieure.

Une telle variante est intéressante pour des raisons pratiques de reprises de contact. Néanmoins, il peut également être intéressant dans d'autres modes de réalisation de réaliser une jauge au centre notamment de l'actionneur.

Par ailleurs, le support peut comporter une couche ou un ensemble de couches et la cavité peut être réalisée dans tout ou partie d'au moins une des couches du support (par exemple par gravure d'une couche sacrificielle du support).

Selon une variante de l'invention, la structure d'actionnement comporte en outre une couche élastique support au dessus de ladite cavité, sur laquelle est située l'électrode inférieure.

Selon une variante de l'invention, la structure d'actionnement comporte une structure dite encastrée-libre comportant un porte-à-faux libre sur trois côtés.

Selon une variante de l'invention, la structure d'actionnement comporte une structure encastrée sur tout ou partie de sa périphérie. Selon une variante de l'invention, la structure d'actionnement comporte en outre au moins une jauge piézoélectrique, la jauge piézorésistive et la jauge piézoélectrique comportant une couche commune choisie parmi la couche d'électrode supérieure et la couche d'électrode inférieure.

Selon une variante de l'invention, la jauge de contrainte piézorésistive comporte au moins deux plots de contact connectés à la jauge piézorésistive situés dans au moins une des couches d'électrodes et au moins deux plots de contacts de l'actionneur piézoélectrique situés dans au moins une des couches d'électrodes.

Selon une variante de l'invention, la jauge piézorésistive est réalisée dans les couches d'électrode inférieure et supérieure.

Selon une variante de l'invention, la structure d'actionnement comporte un ensemble de lignes résistives permettant d'intégrer la jauge piézorésistive dans une structure de pont de Wheatstone.

Selon une variante de l'invention, le matériau piézoélectrique est de type zirconate de plomb et de titane ou de PZT ou de type nitrure d'aluminium ou de type oxyde de zinc (ZnO).

Les couches d'électrodes inférieure et /ou supérieure peuvent avantageusement être en matériau de type platine (Pt) ou tungstène (W) ou aluminium (Al) ou ruthénium (Ru) ou oxyde de ruthénium ($RuO_2$) ou Iridium (Ir), oxyde d'Iridium ($IrO_2$), Cuivre (Cu), Argent (Ag), Nickel (Ni), Chrome (Cr), ou en alliages de ce type de métaux.

La couche élastique support peut avantageusement être en matériau de type Silicium (Si), ou de type oxyde de Silicium ($SiO_2$), ou de type nitrure de Silicium ($Si_xN_y$) ou de polymères conducteurs.

L'invention a aussi pour objet un procédé de fabrication de structure d'actionnement piézoélectrique selon l'invention et comportant les étapes suivante sur un support :

- le dépôt d'une couche d'électrode inférieure ;
- le dépôt d'une couche de matériau piézoélectrique ;
- le dépôt d'une couche d'électrode supérieure ;
- la gravure d'au moins une couche d'électrode au travers d'un masque de manière à définir au moins une jauge de contraintes piézorésistive et au moins un actionneur.

Selon une variante, le procédé comporte en outre le dépôt d'une couche élastique sur un support, sur lequel est déposée la couche d'électrode inférieure.

Selon une variante, le procédé comporte en outre :

- la gravure de l'empilement couche élastique/couche d'électrode inférieure/couche de matériau piézoélectrique définissant une mesa ;
- le dépôt de la couche d'électrode supérieure sur la mesa et le support .

Selon une variante, le procédé comporte la gravure de l'électrode supérieure de manière à définir une jauge piézorésistive à partir de la couche d'électrode supérieure.

Selon une variante, le procédé comporte :

- la gravure de la couche de matériau piézoélectrique sur la couche d'électrode inférieure de manière à définir une mesa de matériau piézoélectrique de plus petites dimensions ;
- le dépôt de la couche d'électrode supérieure sur la couche de matériau piézoélectrique et sur la couche d'électrode inférieure ;
- la gravure de l'ensemble des couches d'électrode supérieure et d'électrode inférieure de manière à définir la jauge piézorésistive dans l'empilement des deux couches d'électrodes.

L'invention sera mieux comprise et d'autres avantages apparaîtront à la lecture de la description qui va suivre donnée à titre non limitatif et grâce aux figures annexées parmi lesquelles :

- la figure 1 illustre un premier exemple de structure d'actionnement piézoélectrique comportant une jauge de contraintes piézoélectrique selon l'art connu ;
- la figure 2 illustre un second exemple de structure d'actionnement piézoélectrique comportant une jauge de contraintes piézorésistive selon l'art connu ;
- la figure 3 illustre un troisième exemple de structure d'actionnement piézoélectrique comportant une jauge de contraintes piézorésistive selon l'art connu ;
- les figures 4a à 4d illustrent une variante de réalisation de l'invention dans laquelle la jauge piézorésistive est réalisée au sein de la couche d'électrode supérieure ;
- la figure 5 illustre une variante de l'invention intégrant en outre une jauge piézoélectrique ;
- les figures 6a à 6d illustrent une variante de l'invention dans laquelle, la jauge piézorésistive est élaborée grâce aux deux couches d'électrodes inférieure et supérieure ;
- la figure 7 illustre une variante dans laquelle la jauge piézorésistive est intégrée dans une structure de pont de Wheatstone ;
- la figure 8 illustre une vue en coupe d'un exemple d'empilement détaillé de couches utilisé dans une structure d'actionnement piézoélectrique selon l'invention ;
- la figure 9 illustre la comparaison des mesures obtenues en terme de déflexion d'une structure comportant une jauge piézorésistive entre une mesure directe de la résistance et une mesure optique de la déflexion ;
- la figure 10 la comparaison des mesures obtenues en terme de déflexion d'une structure comportant une jauge piézorésistive entre une mesure de la résistance avec un pont de Wheatstone et une mesure optique de la déflexion.

L'invention propose ainsi une structure d'actionnement piézoélectrique comportant un empilement d'au moins une couche piézoélectrique disposée entre une électrode inférieure et une électrode supérieure, cet empilement étant disposé sur une couche support et au moins une jauge de contrainte piézorésistive réalisée dans la même couche que l'électrode supérieure et/ou inférieure. La jauge piézorésistive est réalisée par photolithographie d'une ou des électrodes.

Ainsi, l'intégration d'une jauge de contraintes métallique sans rajouter d'étapes technologiques supplémentaires sur une structure utilisant un actionnement piézoélectrique permet de réaliser un dispositif où l'actionnement et la mesure de déflexion sont complètement intégrés sans surcoût ni étape technologique supplémentaire. En utilisant une jauge de contraintes à la place d'une jauge piézoélectrique, on maximise la surface liée à l'actionnement sans dégrader la zone servant à la mesure de la déflexion.

Avantageusement et selon une variante de l'invention, la structure d'actionnement est réalisée à la surface d'une couche dite élastique, permettant également une déformation dans un sens perpendiculaire au plan de la structure (hors plan). Néanmoins, l'invention peut être également appliquée dans le cas d'une couche piézoélectrique insérée entre deux niveaux de couches d'électrodes, sans présence de couche élastique.

De manière générale, le procédé de réalisation de la jauge comprend notamment les étapes suivantes :

1) le dépôt de la couche élastique et de l'électrode inférieure ;
2) le dépôt du matériau piézoélectrique ;
3) la gravure du matériau piézoélectrique ;
4) le dépôt de l'électrode supérieure ;
5) la gravure d'une ou de deux couches d'électrodes pour la réalisation de la jauge.

Ainsi, la réalisation de la jauge est incluse dans l'étape 5. Sa mise en oeuvre ne nécessite aucune étape supplémentaire, uniquement le rajout de la ligne résistive sur le masque. La meilleure façon de maximiser la surface dédiée à l'actionnement piézoélectrique est de réaliser la ligne piézorésistive constitutive de la jauge sur le pourtour de la structure.

Cette structure peut être de type encastrée-libre, il peut s'agir d'un porte-à-faux libre sur trois côtés.

Cette structure peut également être de type encastrée-encastrée, il peut ainsi s'agir de poutre ou de membrane libre sur deux côtés.

Selon une première variante de l'invention illustrée sur les figures 4a à 4d, la jauge piézorésistive est réalisée au sein de l'électrode supérieure.

Plus précisément, à la surface d'un support non représenté, on réalise l'empilement de couches suivant :

- une couche élastique 45 ;
- une couche d'électrode inférieure 43 ;
- une couche de matériau piézoélectrique 42.

L'ensemble est gravé de manière à définir une mesa , sur laquelle on vient déposer une couche d'électrode supérieure 44, comme illustré en figure 4a.

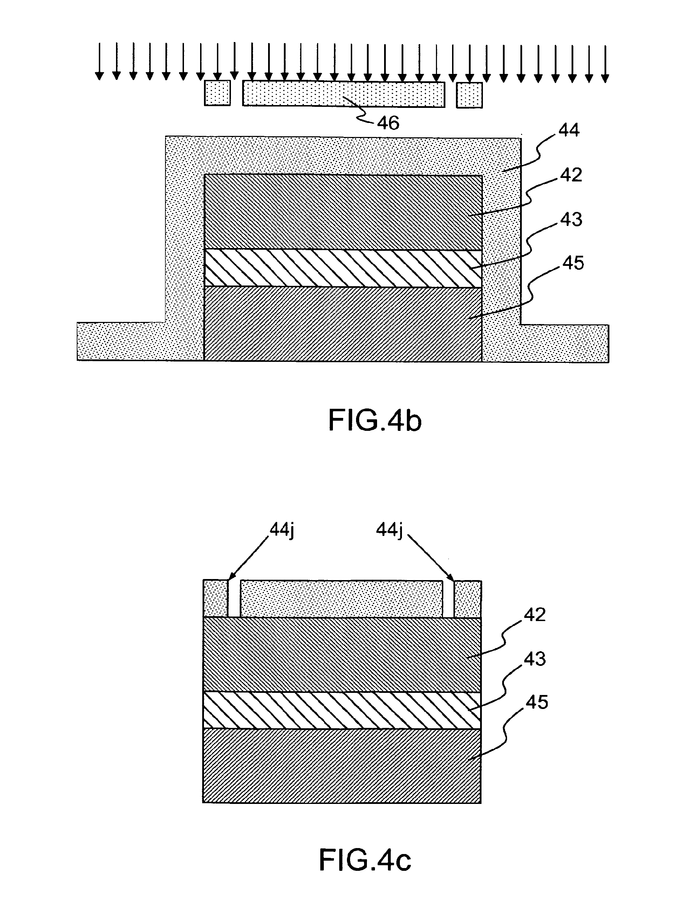

A l'aide d'un masque de photolithographie on vient réaliser une opération de photolithographie comme illustré en figure 4b. Par souci de simplification, cette figure n'illustre pas la couche de résine qui est déposée sur la couche 44 puis insolée à travers le masque 46, puis développée pour permettre la gravure de ladite couche 44, cette résine étant éliminée après gravure.

On obtient comme illustré en figure 4c, des découpes au sein de la couche d'électrode supérieure de manière à créer des discontinuités et ainsi définir les éléments 44j constitutifs de la jauge piézorésistive.

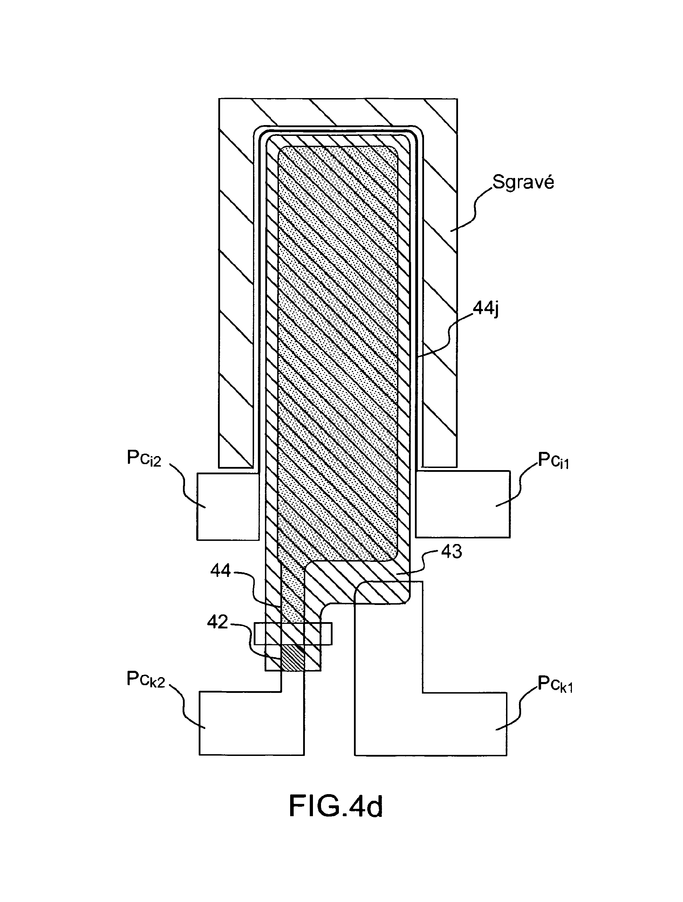

La figure 4d illustre une vue de dessus d'une telle structure, mettant en exergue les différents éléments : actionneur et jauge piézorésistive. La partie jauge piézorésistive 44j est connectée à des plots de contacts $Pci_1$ et $Pci_2$, la partie actionneur est connectée à des plots de contacts $Pck_1$ et $Pck_2$.

Plus précisément, le plot $Pck_1$ connecte l'électrode inférieure, le plot $Pck_2$ connectant l'électrode supérieure. La partie hachurée est relative à la couche de matériau piézoélectrique 43, la couche d'électrode inférieure étant localement coupée pour permettre la reprise de contact de l'électrode supérieure. Autour de la jauge piézorésistive, est représentée une partie hachurée $S_{gravé}$ , correspondante à la région de substrat gravé permettant de réaliser l'actionneur de type poutre encastrée/ libre. Pratiquement, la couche d'électrode peut être déposée sur une couche intermédiaire sur le substrat à graver. On réalise des ouvertures au niveau de cette couche permettant par la même de réaliser un masque de gravure ultérieure, du substrat.

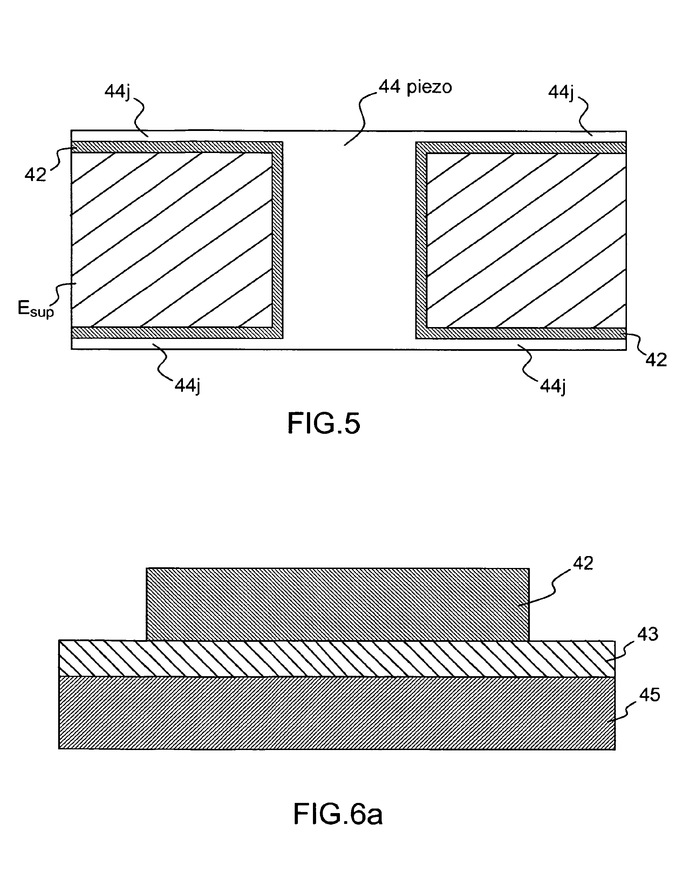

La figure 5 illustre une vue de dessus d'une variante de l'invention dans laquelle, des jauges piézorésistives sont également réalisées au sein de la couche d'électrode supérieure, ladite structure d'actionnement comportant en outre une jauge piézoélectrique en partie centrale. Comme représenté sur la figure 5, la structure d'actionnement présente deux jauges métalliques 44j et une jauge piézoélectrique centrale $44_{piézo}$, les électrodes d'actionnement du matériau piézoélectrique $E_{sup}$ et la zone de métal gravée correspondant à la surface du matériau piézoélectrique 42. La jauge piézoélectrique et les jauges métalliques sont faites dans la même électrode.

On utilise un type de jauge ou l'autre selon le câblage des points de contact électriques couramment dénommés « pads ». L'avantage de combiner les deux types de jauges est de pouvoir choisir l'une ou l'autre des méthodes de détection selon la situation. En fonctionnement dynamique, on pourra choisir la jauge piézoélectrique car la mesure de la jauge de contraintes sera limitée par le bruit. Si l'on applique une contrainte statique, les charges générées par le matériau piézoélectrique vont s'évacuer progressivement. Par contre la résistance de la jauge de contraintes ne va pas évoluer avec le temps. En statique, il vaut donc mieux utiliser la jauge de contraintes.

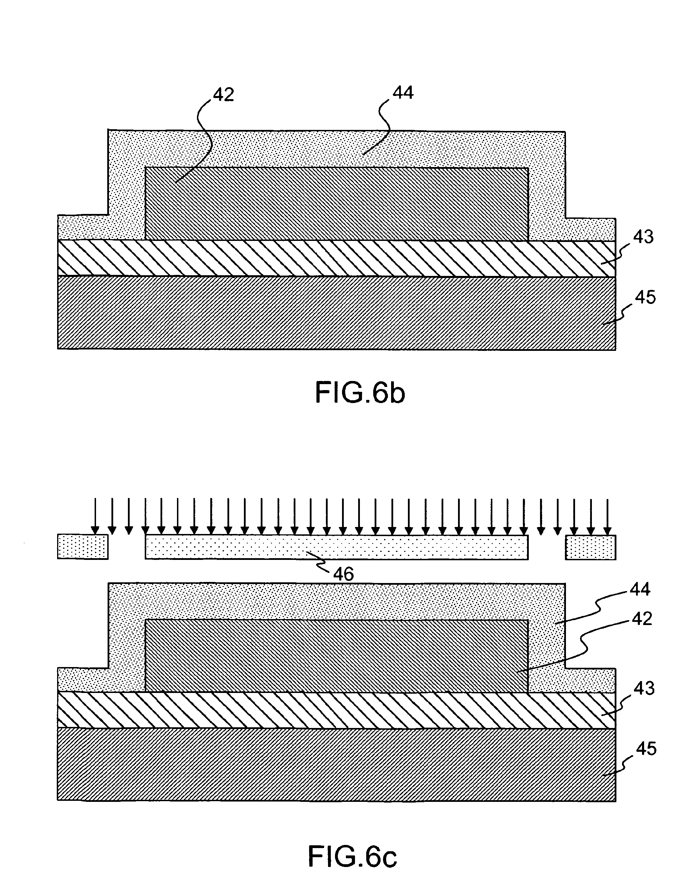

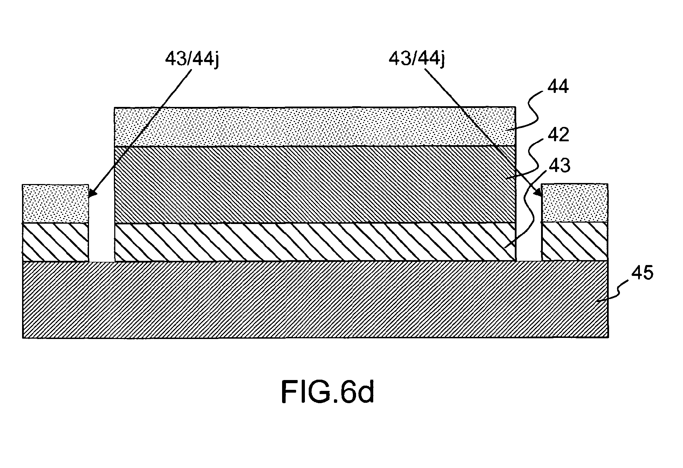

Selon une autre variante de l'invention, il est proposé de réaliser la jauge de contraintes métallique en utilisant les deux couches d'électrodes 43 et 44. De cette façon on augmente l'épaisseur de la ligne résistive, ce qui en diminue la résistance. Avant de déposer la couche d'électrode supérieure 44, on grave le matériau piézoélectrique 42 comme représenté en figure 6a de façon à mettre en contact les deux électrodes sur la surface de la structure, comme présenté figure 6b. De la même façon que lorsque l'on réalise la jauge sur l'électrode supérieure uniquement selon la première variante, on vient laisser une ligne résistive le long de la structure au travers d'un masque 46 de photolithographie comme présenté figure 6c (selon les mêmes étapes non représentées décrites pour la figure 4b). La structure obtenue est illustrée en figure 6d et met en évidence les éléments de jauge piézorésistive 43/44j.

Selon une autre variante de l'invention, la structure d'actionnement piézoélectrique peut comprendre une jauge piézorésistive intégrée dans une structure de montage de pont de Wheatstone. Une telle configuration permet d'augmenter la résolution de la jauge de contraintes.

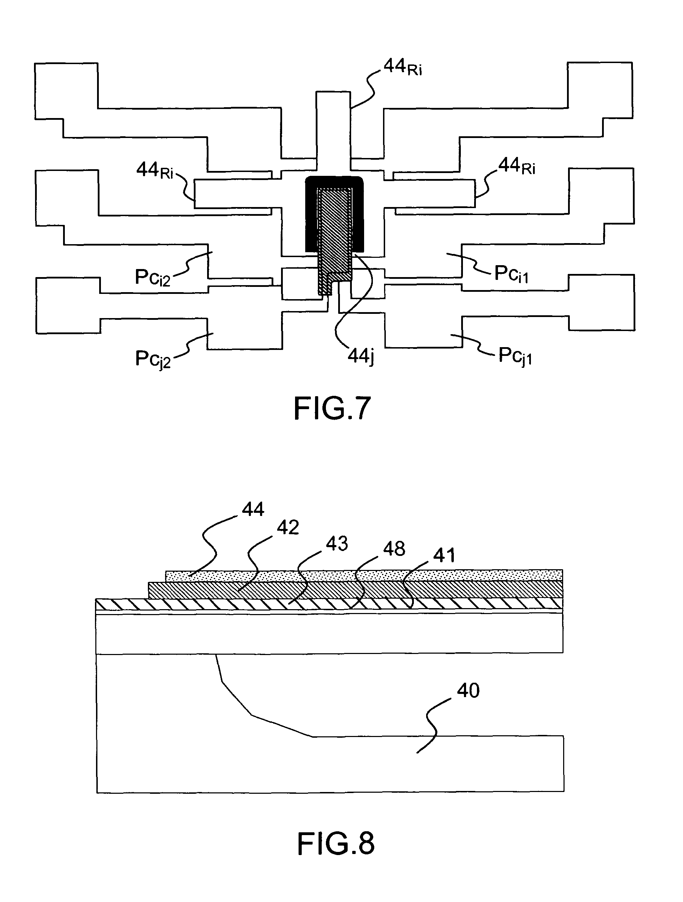

Les autres résistances du pont peuvent être réalisées de la même façon par photolithographie, en laissant des lignes résistives $44_{Ri}$ sur le substrat, au niveau de zones non libérées contrairement à celle constitutive de la jauge piézorésistive 44j. La figure 7 illustre ainsi une telle structure d'actionnement piézoélectrique.

De manière générale, le principe de la mesure utilisant une structure d'actionnement piézoélectrique est le suivant :

La variation de résistance d'une ligne métallique est proportionnelle à son élongation :

$$\frac{\Delta R}{R} = K \frac{\Delta L}{L}$$ où K est le facteur de jauge, L la longueur de la jauge et R sa résistance.

Dans le cas de la présente invention, la jauge fait le tour du porte-à-faux couramment dénommé « cantilever ». La variation de résistance est donc deux fois plus importante puisqu'elle intervient sur les deux branches de la jauge.

Par effet Poisson, si L augmente, la largeur de la poutre diminue. La partie de ligne située à l'extrémité du cantilever se contracte. La variation de la résistance en fonction de l'élongation du cantilever devient donc :

$$\frac{\Delta R}{R} = K.(2 - \nu_{CE}).\frac{\Delta L}{L}$$ où $\nu_{CE}$ est le coefficient de Poisson de la couche élastique.

L'élongation du cantilever peut s'exprimer de la façon suivante :

$$\frac{\Delta L}{L} = \frac{e}{R_c}$$ où e est la distance entre la jauge et la fibre neutre et $R_c$ le rayon de courbure du cantilever. Si l'on considère ce rayon de courbure uniforme sur toute la longueur de la poutre :

$$R_c = \frac{L^2}{2.Z}$$ où Z est la déflexion en bout de poutre.

La relation entre la déflexion et la variation de résistance est donc :

$$Z = \frac{\Delta R}{R}.\frac{L^2}{2.K.(2 - \nu_{CE}).e}$$

Dans le cas d'un montage en pont de Wheatstone simple, la tension de sortie est :

$$V_{out} = \frac{V_{in}}{4}.\frac{\Delta R}{R}$$ où $V_{in}$ est la tension de polarisation

du pont et $V_{out}$ la tension de sortie.

Exemple de réalisation

Selon la structure de l'invention, une jauge de contraintes piézorésistive est intégrée sur une poutre encastrée - libre.

Cette structure comprend l'empilement de couches suivant à la surface d'un substrat de silicium :

- un substrat de silicium ;
- une couche élastique de SiN de 1 micron d'épaisseur ;
- une couche d'accroche en $TiO_2$ de 2 nanomètres d'épaisseur ;
- une électrode inférieure de Pt de 50 nanomètres d'épaisseur ;
- une couche de PZT de 120 nanomètres d'épaisseur ;
- une couche d'électrode supérieure en Pt de 25 nanomètres d'épaisseur.

Comme illustré en figure 8, la structure est réalisée sur un substrat de silicium 40 et utilise une couche élastique 41. La couche élastique est faite en SiN préférée au $SiO_2$ et permet de compenser les contraintes résiduelles dans la structure libérée.

Le matériau piézoélectrique 42 est le PZT. Des zones de SiN sont dégagées de manière à pouvoir réaliser une gravure sous jacente du substrat silicium et ainsi obtenir la structure de poutre telle que représentée.

Le film de PZT est déposé par technique sol-gel sur l'empilement standard composant l'électrode inférieure 43 sur une couche d'accroche 48. Les films sol gel sont réalisés à partir d'une solution commerciale, contenant 10% d'excès de précurseur du plomb pour éviter les lacunes de plomb lors des recuits de cristallisation. Chaque dépôt d'une couche de PZT par spin coating donne à la fin du process une épaisseur de PZT entre 50 et 60 nm. L'épaisseur finale de PZT est obtenue en ajustant le nombre de dépôts par spin coating. Le procédé standard pour le dépôt PZT est :

- dépôt par spin coating (tournette)
- calcination à 400°C sous air pendant 5 min
- recuit rapide de cristallisation du PZT à 700°C pendant 1 minute sous oxygène.

Le recuit de cristallisation permet d'obtenir la phase perovskite du PZT. Les films de PZT déposés font de quelques nm à quelques $\mu$m et par exemple 1 $\mu$m. L'électrode supérieure 44 est aussi faite en platine déposé par pulvérisation.

De cette façon, le profil de la poutre est très plat. Toutes les couches de l'empilement piézoélectrique Pt/PZT/Pt ont un stress tensile après recuit du PZT. Le stress résiduel du Pt est 1.1 GPa et celui du PZT 200 MPa. La seule façon de compenser ces contraintes résiduelles est d'utiliser une couche dont le stress sera tensile, correspondant à un matériau soumis à une contrainte de traction.

Comme le procédé final de libération de gravure est opéré avec le gaz $XeF_2$ (pour graver le silicium), le silicium ne peut être utilisé comme couche élastique. Le $SiO_2$ a toujours un stress compressif. Le SiN est alors un meilleur choix pour compenser les contraintes car il peut avoir un stress tensile. Le SiN riche en Si a un stress de 400 MPa.

Afin de valider l'intérêt en terme de performances de la jauge utilisée dans une structure d'actionnement piézoélectrique de l'invention, la demanderesse a effectué des mesures de la déflexion par la jauge piézorésistive précédemment décrite et comparé ces mesures avec celles obtenues par une méthode optique classique de mesure de déflexion réalisée grâce à un interféromètre en lumière blanche.

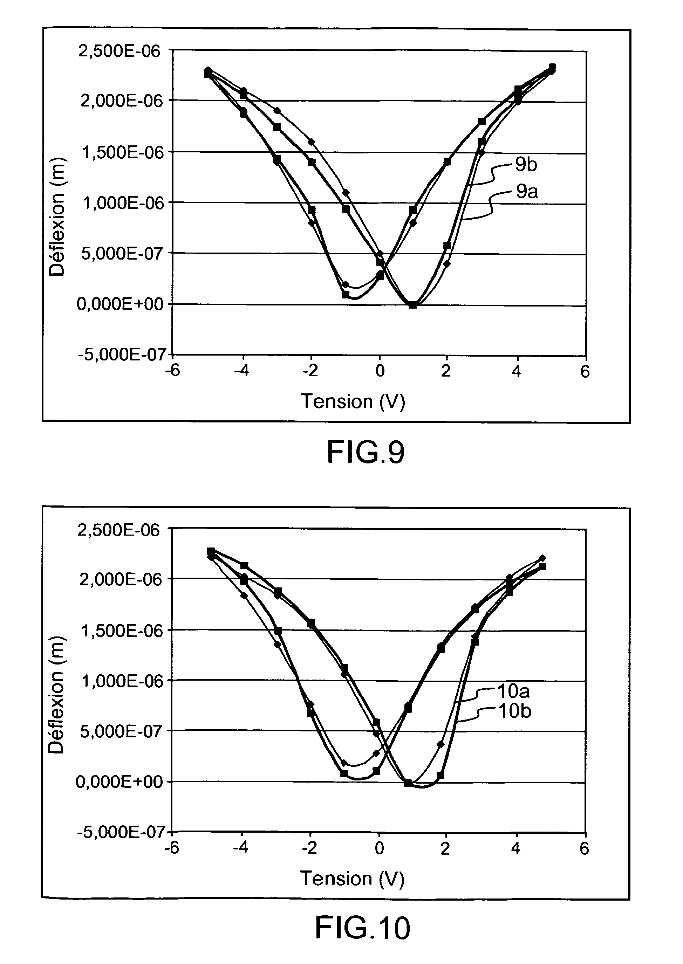

Les mesures ont été réalisées par mesure directe de variation de résistance et par un pont de Wheatstone en utilisant une tension de pont de 1v pour limiter le courant de la jauge, et sont illustrées en figures 9 et 10, les courbes 9a et 10a étant relatives aux mesures optiques, les courbes 9b et 10b étant relatives aux mesures par la jauge piézorésistive, donnant en fonction d'une tension de polarisation, des valeurs de déflexion.

Les mesures de déflexion sont déduites des équations explicitées à partir des mesures de variations de résistance. Il ressort de ces courbes qu'il est possible d'atteindre le même degré de précision que des mesures classiques optiques et ce en utilisant une structure tout intégrée de technologie très directe.

**Revendications**

1. Structure d'actionnement piézoélectrique comportant au moins une jauge de contraintes et au moins un actionneur réalisé à partir d'un empilement à la surface d'un support d'au moins une couche de matériau piézoélectrique (42) disposée entre une couche d'électrode inférieure (43) et une couche d'électrode supérieure (44), au moins une partie de l'empilement formant l'actionneur étant disposé au dessus d'une cavité réalisée dans le support **caractérisée en ce que** la jauge de contrainte est une jauge piézorésistive (44j, 43/44j) située dans la couche d'électrode supérieure et/ou la couche d'électrode inférieure ,la ou lesdites couches comportant des discontinuités d'électrodes permettant la réalisation de ladite jauge piézorésistive.

2. Structure d'actionnement selon la revendication 1, **caractérisée en ce que** la jauge piézorésistive est réalisée dans au moins une partie de la couche d'électrode supérieure et/ou de la couche d'électrode inférieure située au-dessus de la cavité.

3. Structure d'actionnement selon la revendication 2, **caractérisée en ce que** ladite jauge piézorésistive est réalisée sur au moins une partie du pourtour de l'électrode supérieure et/ou inférieure.

4. Structure d'actionnement piézoélectrique selon l'une des revendications 1 à 3, **caractérisée en ce qu'**elle comporte en outre une couche élastique (41) support au dessus de ladite cavité, sur laquelle est située l'électrode inférieure.

5. Structure d'actionnement piézoélectrique selon l'une des revendications 1 à 4, **caractérisée en ce qu'**elle comporte une structure dite encastrée-libre comportant un porte-à-faux libre sur trois côtés.

6. Structure d'actionnement piézoélectrique selon l'une des revendications 1 à 4, **caractérisée en ce qu'**il comporte une structure encastrée sur tout ou partie de sa périphérie.

7. Structure d'actionnement piézoélectrique selon la revendication 6, **caractérisé en ce qu'**elle comporte en outre au moins une jauge piézoélectrique ($44_{piézo}$), la jauge piézorésistive et la jauge piézoélectrique comportant une couche commune choisie parmi la couche d'électrode supérieure et la couche d'électrode inférieure.

8. Structure d'actionnement piézoélectrique selon la revendication 1, **caractérisée en ce que** la jauge de contrainte piézorésistive comporte au moins deux plots de contact connectés ($Pci_1$, $Pci_2$) à la jauge piézorésistive situés dans au moins une des couches d'électrodes et au moins deux plots de contacts de l'actionneur piézoélectrique ($Pck_1$, $Pck_2$) situés dans au moins une des couches d'électrodes.

9. Structure d'actionnement piézoélectrique selon l'une des revendications 1 à 8, **caractérisée en ce que** la jauge piézorésistive est réalisée dans les couches d'électrodes inférieure et supérieure.

10. Structure d'actionnement piézoélectrique selon l'une des revendications 1 à 9, **caractérisée en ce qu'**elle comporte un ensemble de lignes résistives ($44_{Ri}$) permettant d'intégrer la jauge piézorésistive dans une structure de pont de Wheatstone.

11. Structure d'actionnement piézoélectrique selon l'une des revendications 1 à 10, **caractérisée en ce que** le matériau piézoélectrique est de type zirconate de plomb et de titane ou de PZT ou de type nitrure d'aluminium ou de type oxyde de zinc (ZnO).

12. Structure d'actionnement piézoélectrique selon l'une des revendications 1 à 11, **caractérisée en ce que** les couches d'électrodes inférieures et /ou supérieure sont en matériau de type platine (Pt) ou tungstène (W) ou aluminium (Al) ou ruthénium (Ru) ou oxyde de ruthénium ($RuO_2$) ou Iridium (Ir), oxyde d'Iridium ($IrO_2$), Cuivre (Cu), Argent (Ag), Nickel (Ni), Chrome (Cr), alliages de métaux.

13. Structure d'actionnement piézoélectrique selon la revendication 4, **caractérisée en ce que** la couche élastique support est en matériau de type Silicium (Si), ou de type oxyde de Silicium ($SiO_2$), ou de type nitrure de Silicium ($Si_xN_y$) ou de type polymères conducteurs.

14. Procédé de fabrication d'une structure d'actionnement piézoélectrique selon l'une des revendications 1 à 13, **caractérisé en ce qu'**il comporte les étapes suivante sur un support :

   - le dépôt d'une couche d'électrode inférieure ;
   - le dépôt d'une couche de matériau piézoélectrique ;
   - le dépôt d'une couche d'électrode supérieure ;
   - la gravure d'au moins une couche au travers d'un masque de manière à définir au moins une jauge de contrainte piézorésistive et au moins un actionneur.

**15.** Procédé de fabrication d'une structure d'actionnement piézoélectrique selon la revendication 14, **caractérisé en ce qu'**il comporte en outre le dépôt d'une couche élastique sur un support, sur lequel est déposée la couche d'électrode inférieure.

**16.** Procédé de fabrication d'un actionneur piézoélectrique selon la revendication 15, **caractérisé en ce qu'**il comporte en outre :

- la gravure de l'empilement couche élastique/couche d'électrode inférieure/couche de matériau piézoélectrique définissant une mesa ;
- le dépôt de la couche d'électrode supérieure sur la mesa et le support.

**17.** Procédé de fabrication d'une structure d'actionnement piézoélectrique selon l'une des revendications 14 ou 15, **caractérisé en ce qu'**il comporte la gravure de l'électrode supérieure de manière à définir une jauge piézorésistive à partir de la couche d'électrode supérieure.

**18.** Procédé de fabrication d'une structure d'actionnement piézoélectrique selon l'une des revendications 1 à 13, **caractérisé en ce qu'**il comporte :

- la gravure de la couche de matériau piézoélectrique sur la couche d'électrode inférieure de manière à définir une mesa de matériau piézoélectrique de plus petites dimensions ;
- le dépôt de la couche d'électrode supérieure sur la couche de matériau piézoélectrique et sur la couche d'électrode inférieure.
- la gravure de l'ensemble des couches d'électrode supérieure et d'électrode inférieure de manière à définir la jauge piézorésistive dans l'empilement des deux couches d'électrodes.

**Patentansprüche**

**1.** Piezoelektrische Erregungsstruktur, die wenigstens einen Dehnungsmessstreifen und wenigstens einen Aktuator umfasst, der von einem Stapel auf der Oberfläche eines Trägers von wenigstens einer Schicht aus piezoelektrischem Material (42) gebildet ist, die zwischen einer unteren Elektrodenschicht (43) und einer oberen Elektrodenschicht (44) angeordnet ist, wobei wenigstens ein Teil des den Aktuator bildenden Stapels über einem in dem Träger ausgebildeten Hohlraum angeordnet ist, **dadurch gekennzeichnet, dass** der Dehnungsmessstreifen ein piezoresistiver Messstreifen (44j, 43/44j) ist, der sich in der oberen Elektrodenschicht und/oder der unteren Elektrodenschicht befindet, wobei die Schicht(en) Elektrodendiskontinuitäten aufweist/-en, mit denen der piezoresistive Messstreifen realisiert werden kann.

**2.** Erregungsstruktur nach Anspruch 1, **dadurch gekennzeichnet, dass** der piezoresistive Messstreifen in wenigstens einem über dem Hohlraum befindlichen Teil der oberen Elektrodenschicht und/oder der unteren Elektrodenschicht realisiert ist.

**3.** Erregungsstruktur nach Anspruch 2, **dadurch gekennzeichnet, dass** der piezoresistive Messstreifen auf wenigstens einem Teil des Perimeters der oberen und/oder unteren Elektrode realisiert ist.

**4.** Piezoelektrische Erregungsstruktur nach einem der Ansprüche 1 bis 3, **dadurch gekennzeichnet, dass** sie ferner eine elastische Trägerschicht (41) über dem Hohlraum umfasst, auf der sich die untere Elektrode befindet.

**5.** Piezoelektrische Erregungsstruktur nach einem der Ansprüche 1 bis 4, **dadurch gekennzeichnet, dass** sie eine als eingebaut-frei bezeichnete Struktur umfasst, die einen freitragenden Träger auf drei Seiten aufweist.

**6.** Piezoelektrische Erregungsstruktur nach einem der Ansprüche 1 bis 4, **dadurch gekennzeichnet, dass** sie eine eingebaute Struktur auf ihrer gesamten oder einem Teil ihrer Peripherie umfasst.

**7.** Piezoelektrische Erregungsstruktur nach Anspruch 6, **dadurch gekennzeichnet, dass** sie ferner wenigstens einen piezoelektrischen Messstreifen ($44_{piezo}$) umfasst, wobei der piezoresistive Messstreifen und der piezoelektrische Messstreifen eine gemeinsame Schicht aufweisen, die aus der oberen Elektrodenschicht und der unteren Elektrodenschicht ausgewählt ist.

**8.** Piezoelektrische Erregungsstruktur nach Anspruch 1, **dadurch gekennzeichnet, dass** der piezoresistive Dehnungsmessstreifen wenigstens zwei mit dem piezoresistiven Messstreifen verbundene Kontaktblöcke ($Pci_1$, $Pci_2$) umfasst, die sich in wenigstens einer der Elektrodenschichten befindet, und wenigstens zwei Kontaktblöcke ($Pck_1$, $Pck_2$) des piezoelektrischen Aktuators, die sich in wenigstens einer der Elektrodenschichten befinden.

**9.** Piezoelektrische Erregungsstruktur nach einem der Ansprüche 1 bis 8, **dadurch gekennzeichnet, dass** der piezoresistive Messstreifen in der unteren und der oberen Elektrodenschicht realisiert ist.

**10.** Piezoelektrische Erregungsstruktur nach einem der Ansprüche 1 bis 9, **dadurch gekennzeichnet, dass** sie einen Satz von resistiven Leitungen ($44_{Ri}$) umfasst, die eine Integration des piezoresistiven Messstreifens in eine Wheatstone-Brückenstruktur zulassen.

11. Piezoelektrische Erregungsstruktur nach einem der Ansprüche 1 bis 10, **dadurch gekennzeichnet, dass** das piezoelektrische Material vom Blei- und Titanzirkonat- oder PZT-Typ oder vom Aluminiumnitrid- oder Zinkoxidtyp (ZnO) ist.

12. Piezoelektrische Erregungsstruktur nach einem der Ansprüche 1 bis 11, **dadurch gekennzeichnet, dass** die untere und/oder obere Elektrodenschicht aus einem Material des Typs Platin (Pt) oder Wolfram (W) oder Aluminium (Al) oder Ruthenium (Ru) oder Rutheniumoxid ($RuO_2$) oder Iridium (Ir), Iridiumoxid ($IrO_2$), Kupfer (Cu), Silber (Ag), Nickel (Ni), Chrom (Cr) oder Metalllegierung ist.

13. Piezoelektrische Erregungsstruktur nach Anspruch 4, **dadurch gekennzeichnet, dass** die elastische Trägerschicht aus einem Material des Siliciumtyps (Si) oder des Siliciumoxidtyps ($SiO_2$) oder des Siliciumnitridtyps ($Si_xN_y$) oder des leitenden Polymertyps ist.

14. Verfahren zur Herstellung einer piezoelektrischen Erregungsstruktur nach einem der Ansprüche 1 bis 13, **dadurch gekennzeichnet, dass** es das Ausführen der folgenden Schritte auf einem Träger beinhaltet:

- Absetzen einer unteren Elektrodenschicht;
- Absetzen einer Schicht aus piezoelektrischem Material;
- Absetzen einer oberen Elektrodenschicht;
- Ätzen von wenigstens einer Schicht durch eine Maske, um wenigstens einen piezoresistiven Dehnungsmessstreifen und wenigstens einen Aktuator zu definieren.

15. Verfahren zur Herstellung einer piezoelektrischen Erregungsstruktur nach Anspruch 14, **dadurch gekennzeichnet, dass** es ferner das Absetzen einer elastischen Schicht auf einen Träger beinhaltet, auf dem die untere Elektrodenschicht abgesetzt ist.

16. Verfahren zur Herstellung einer piezoelektrischen Erregungsstruktur nach Anspruch 15, **dadurch gekennzeichnet, dass** es ferner Folgendes beinhaltet:

- Ätzen des Stapels aus elastischer Schicht/unterer Elektrodenschicht/Schicht aus piezoelektrischem Material zum Definieren einer Mesa;
- Absetzen der oberen Elektrodenschicht auf die Mesa und auf den Träger.

17. Verfahren zur Herstellung einer piezoelektrischen Erregungsstruktur nach Anspruch 14 oder 15, **dadurch gekennzeichnet, dass** es das Ätzen der oberen Elektrode beinhaltet, um einen piezoresistiven Messstreifen von der oberen Elektrodenschicht zu definieren.

18. Verfahren zur Herstellung einer piezoelektrischen Erregungsstruktur nach einem der Ansprüche 1 bis 13, **dadurch gekennzeichnet, dass** es ferner Folgendes beinhaltet:

- Ätzen der Schicht aus piezoelektrischem Material auf der unteren Elektrodenschicht, um eine kleiner dimensionierte Mesa aus piezoelektrischem Material zu definieren;
- Absetzen der oberen Elektrodenschicht auf die Schicht aus piezoelektrischem Material und auf die untere Elektrodenschicht;
- Ätzen des Satzes von oberen Elektrodenschichten und unteren Elektrodenschichten, um den piezoresistiven Messstreifen in dem Stapel der zwei Elektrodenschichten zu definieren.

## Claims

1. A piezoelectric actuating structure comprising at least one strain gauge and at least one actuator realised from a stack, on the surface of a support, of at least one layer of piezoelectric material (42) that is disposed between a lower electrode layer (43) and an upper electrode layer (44), at least one part of said stack that forms said actuator being disposed above a cavity that is realised in said support, **characterised in that** said strain gauge is a piezoresistive gauge (44j, 43/44j) that is located in said upper electrode layer and/or said lower electrode layer, said one or more layers comprising discontinuities of electrodes allowing the realisation of said piezoresistive gauge.

2. The actuating structure according to claim 1, **characterised in that** said piezoresistive gauge is realised in at least one part of said upper electrode layer and/or of said lower electrode layer that is located above said cavity.

3. The actuating structure according to claim 2, **characterised in that** said piezoresistive gauge is realised on at least one part of the perimeter of the upper and/or lower electrode.

4. The piezoelectric actuating structure according to any one of claims 1 to 3, **characterised in that** it further comprises an elastic support layer (41) above said cavity, on which said lower electrode is located.

**5.** The piezoelectric actuating structure according to any one of claims 1 to 4, **characterised in that** it comprises a structure, referred to as a fixed-free structure, that comprises a free cantilever on three sides.

**6.** The piezoelectric actuating structure according to any one of claims 1 to 4, **characterised in that** it comprises a fixed structure on all or part of its periphery.

**7.** The piezoelectric actuating structure according to claim 6, **characterised in that** it further comprises at least one piezoelectric gauge ($44_{piezo}$), said piezoresistive gauge and said piezoelectric gauge comprising a common layer that is selected from said upper electrode layer and said lower electrode layer.

**8.** The piezoelectric actuating structure according to claim 1, **characterised in that** said piezoresistive strain gauge comprises at least two contact blocks ($Pci_1$, $Pci_2$) that are connected to said piezoresistive gauge located in at least one of said electrode layers and at least two contact blocks ($Pck_1$, $Pck_2$) of said piezoelectric actuator located in at least one of said electrode layers.

**9.** The piezoelectric actuating structure according to any one of claims 1 to 8, **characterised in that** said piezoresistive gauge is realised in the lower and upper layers of electrodes.

**10.** The piezoelectric actuating structure according to any one of claims 1 to 9, **characterised in that** it comprises a set of resistive lines ($44_{Ri}$) allowing said piezoresistive gauge to be integrated into a Wheatstone bridge structure.

**11.** The piezoelectric actuating structure according to any one of claims 1 to 10, **characterised in that** the piezoelectric material is of the lead zirconate and titanium or PZT type or of the aluminium nitride or zinc oxide (ZnO) type.

**12.** The piezoelectric actuating structure according to any one of claims 1 to 11, **characterised in that** said lower and/or upper electrode layers are made from a material of the platinum (Pt) or tungsten (W) or aluminium (Al) or ruthenium (Ru) or ruthenium oxide ($RuO_2$) or iridium (Ir), iridium oxide ($IrO_2$), copper (cu), silver (Ag), nickel (Ni), chrome (Cr) or metal alloy type.

**13.** The piezoelectric actuating structure according to claim 4, **characterised in that** said elastic support layer is made from a material of the silicon (Si) type or of the silicon oxide ($SiO_2$) type or of the silicon nitride ($Si_xN_y$) type or of the conducting polymer type.

**14.** A method for manufacturing a piezoelectric actuating structure according to anyone of claims 1 to 13, **characterised in that** it comprises carrying out the following steps on a support:

- depositing a lower electrode layer;
- depositing a layer of piezoelectric material;
- depositing an upper electrode layer;
- etching at least one layer through a mask so as to define at least one piezoresistive strain gauge and at least one actuator.

**15.** The method for manufacturing a piezoelectric actuating structure according to claim 14, **characterised in that** it further comprises depositing an elastic layer onto a support, on which said lower electrode layer is deposited.

**16.** The method for manufacturing a piezoelectric actuating structure according to claim 15, **characterised in that** it further comprises:

- etching the elastic layer/lower electrode layer/layer of piezoelectric material stack to define a mesa;
- depositing said upper electrode layer onto said mesa and said support.

**17.** The method for manufacturing a piezoelectric actuating structure according to claim 14 or 15, **characterised in that** it comprises etching said upper electrode so as to define a piezoresistive gauge from said upper electrode layer.

**18.** The method for manufacturing a piezoelectric actuating structure according to any one of claims 1 to 13, **characterised in that** it comprises:

- etching said layer of piezoelectric material on said lower electrode layer so as to define a smaller sized mesa of piezoelectric material;
- depositing said upper electrode layer onto said layer of piezoelectric material and onto said lower electrode layer;
- etching the set of upper electrode layers and lower electrode layers so as to define said piezoresistive gauge in the stack of said two electrode layers.

FIG.1

FIG.2

FIG.3

FIG.4a

FIG.4b

FIG.4c

FIG.4d

44j          44 piezo          44j

42

$E_{sup}$

44j          44j      42

**FIG.5**

42

43

45

**FIG.6a**

FIG.6b

FIG.6c

FIG.6d

$44_{Ri}$

$44_{Ri}$          $44_{Ri}$

$Pc_{i2}$          $Pc_{i1}$

$Pc_{j2}$     $44j$     $Pc_{j1}$

## FIG.7

44  42  43  48  41

40

## FIG.8

FIG.9

FIG.10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2009003804 A, H. Tang
- US 20090038404 A1
- US 6075585 A

**Littérature non-brevet citée dans la description**

- A fatigue test method for Pb(Zr,Ti)O3 thin films by using MEMS-based self-sensitive piezoelectric microcantilevers. **T. KOBAYASHI et al.** Journal of Micromechanics and Microengineering. National Institute of Advanced Industrial Science and Technology, 2008, vol. 18, 115007, 6

- High-Q and CMOS compatible single crystal silicon cantilever with separated on-chip piezoelectric actuator for ultra-sensitive mass detection. **J. LU et al.** MEMS 2008. National Institute of Advanced Industrial Science and Technology, 13 Janvier 2008